# EUROPÄISCHE PATENTSCHRIFT

(11) **EP 2 628 818 B1**
(45) Veröffentlichungstag und Bekanntmachung des Hinweises auf die Patenterteilung: **05.10.2016**
(21) Anmeldenummer: 13154482.7
(22) Anmeldetag: 07.02.2013
(51) Int. Cl.: C23C 14/08, C23C 14/35, C23C 14/54, G02B 1/115

(54) **GEGENSTAND MIT REFLEXIONSMINDERNDER BESCHICHTUNG, VERFAHREN ZU DESSEN HERSTELLUNG SOWIE VERWENDUNG DES GEGENSTANDS**
ARTICLE WITH REFLECTION REDUCING COATING, METHOD FOR PRODUCING THE SAME, AND USE OF THE ARTICLE
OBJET AVEC REVÊTEMENT ANTI-RÉFLÉCHISSANT, SON PROCÉDÉ DE FABRICATION ET UTILISATION DE L'OBJET

(30) Priorität: 14.02.2012 DE 102012002927
(43) Veröffentlichungstag der Anmeldung: 21.08.2013
(73) Patentinhaber: Fraunhofer-Gesellschaft zur Förderung der angewandten Forschung e.V., 80686 München (DE); W. Blösch AG, 2540 Grenchen (CH)
(72) Erfinder: Vergöhl, MIchael, 38162 Cremlingen (DE); Rademacher, Daniel, 38110 Braunschweig (DE); Werner, Oliver, 38118 Braunschweig (DE); Bruns, Stefan, 38162 Cremlingen (DE); Neubert, Thomas, 38112 Braunschweig (DE); Weiss, Peter, 2540 Grenchen (CH)

(56) Entgegenhaltungen:
- EP-A1- 1 152 263
- WO-A2-2008/000841
- ALEXIEVA Z I ET AL: "Antireflection coatings for GaAs solar cell applications", JOURNAL OF PHYSICS: CONFERENCE SERIES; 16TH INTERNATIONAL SUMMER SCHOOL ON VACUUM, ELECTRON, AND ION TECHNOLOGIES (VEIT 2009) 28 SEPTEMBER - 2 OCTOBER 2009, SLANCHEV BRYAG (SUNNY BEACH) [BG], Bd. 223, Nr. 1, 012045, 20. Mai 2010 (2010-05-20), Seiten 1-4, XP055058160, IOP Publishing Ltd, Bristol [GB] DOI: 10.1088/1742-6596/223/1/012045
- TEIXEIRA V ET AL: "Deposition of composite and nanolaminate ceramic coatings by sputtering", VACUUM, Bd. 67, Nr. 3-4, 26. September 2002 (2002-09-26), Seiten 477-483, XP002319601, Pergamon Press [GB] ISSN: 0042-207X, DOI: 10.1016/S0042-207X(02)00235-X
- SCANLAN C M ET AL: "Tetragonal zirconia growth by nanolaminate formation", APPLIED PHYSICS LETTERS, Bd. 64, Nr. 26, 27. Juni 1994 (1994-06-27) , Seiten 3548-3550, XP000454609, AIP, AMERICAN INSTITUTE OF PHYSICS, MELVILLE, NY [US] ISSN: 0003-6951, DOI: 10.1063/1.111220
- KOHARA T ET AL: "Deposition of alpha-Al2O3 hard coatings by reactive magnetron sputtering", SURFACE AND COATINGS TECHNOLOGY, vol. 185, no. 2-3, 30 April 2004 (2004-04-30), pages 166-171, XP002538574, ELSEVIER, AMSTERDAM [NL] ISSN: 0257-8972, DOI: 10.1016/J.SURFCOAT.2003.11.017 [retrieved on 2004-04-30]
- KRELL A ET AL: "Nanoindentation hardness of submicrometer alumina ceramics", MATERIALS SCIENCE AND ENGINEERING: A, vol. 307, no. 1-2, 15 June 2001 (2001-06-15), pages 172-181, XP027362214, Elsevier B.V. Amsterdam [NL] ISSN: 0921-5093, DOI: 10.1016/S0921-5093(00)01818-9 [retrieved on 2001-06-15]

## Beschreibung

Die Erfindung betrifft einen Gegenstand mit reflexionsmindernder Beschichtung, ein Verfahren zu dessen Herstellung und die Verwendung dieses Gegenstands. Die reflexionsmindernde Beschichtung zeichnet sich durch eine hohe Schichthärte der Außenschicht aus, wobei die Materialien der Beschichtung einen aufeinander abgestimmten Brechungsindex besitzen.

Insbesondere für hochwertige Zielprodukte besteht ein Bedarf, Beschichtungen bereitzustellen, die einerseits Antireflexeigenschaften besitzen und andererseits auch einen mechanischen Schutz, beispielsweise gegenüber Kratzen, zeigen. Nach dem Stand der Technik werden für Breitband-Antireflexschichten Schichtsysteme aus Siliziumdioxid und Titandioxid oder Siliziumdioxid und Siliziumnitrid eingesetzt. Statt Siliziumdioxid kann auch Magnesiumfluorid Verwendung finden, das einen besonders niedrigen Brechungsindex besitzt. Die genannten Materialien führen aber zu Schichten, deren mechanische Stabilität begrenzt ist.

Die DE 10 2008 054 139 A1 offenbart Glasgegenstände mit einer Kratzschutzbeschichtung, die eine Siliziumoxinitridschicht zur Erhöhung der mechanischen Stabilität aufweist. Die DE 10 2008 054 139 A1 offenbart auch den Einsatz dieses Materials für Antireflexschichtsysteme. Allerdings weisen die beschriebenen Systeme aufgrund des hohen Brechungsindexes von Siliziumoxinitriden eine relativ geringe Reflexionsminderung auf.

Die WO 2008/000841 A2 offenbart zum Stand der Technik, dass Antireflexbeschichtungen vorzugsweise Multischicht-Beschichtungen sind, die insbesondere alternierende Schichten mit hohem Brechungsindex und niedrigem Brechungsindex aufweisen. Um Abrieb und/oder Kratzfestigkeit der Beschichtung und ihre Haftung auf dem Substrat zu verbessern, wird hierbei eine Zwischenschicht (beispielsweise aus SiO₂/Al₂O₃) zwischen Substrat und Antireflexionsschicht angeordnet. Die WO 2008/000841 A2 selbst betrifft einen optischen Gegenstand mit einer mehrschichtigen reflexionsmindernden Beschichtung, der Teilschichten mit hohem und mit niedrigem Brechungsindex aufweist. Durch Optimierung des Verhältnisses von physikalischer Gesamtdicke der Schichten mit niedrigem Brechungsindex (kleiner 1,55) und der Schichten mit hohem Brechungsindex (größer 1,55) werden Beschichtungen mit einer hohen Abriebsfestigkeit erhalten. Die Schicht mit niedrigem Brechungsindex kann dabei SiO₂, MgF₂, ZrF₄, Al₂O₃, AlF₃, andere Aluminium-fluoride oder Al₂O₃/SiO₂ Gemische umfassen. Wenn SiO₂/Al₂O₃ Gemische verwendet werden, kann der Al₂O₃-Anteil bis zu 10 Gew.-% betragen. Zu hohe Al₂O₃-Anteile beeinträchtigen gemäß der WO 2008/000841 A2 die Haftung der Antireflexionsbeschichtung.

Eine Aufgabe der Erfindung ist es, einen Gegenstand mit reflexionsmindernder Beschichtung und ein Verfahren zu dessen Herstellung anzugeben, bei dem die Beschichtung eine möglichst hohe mechanische Stabilität besitzt und gleichzeitig sehr gute reflexionsmindernde Eigenschaften aufweist.

Diese Aufgabe wird durch den Gegenstand mit reflexionsmindernder Beschichtung und das Verfahren zu dessen Herstellung sowie des Verwendung des Gegenstands gemäß den unabhängigen Ansprüchen 1, 8 und 11 gelöst. Weitere Ausgestaltungen und Weiterbildungen sind Gegenstand von Unteransprüchen und gehen weiterhin aus der nachfolgenden Beschreibung hervor.

Ein erfindungsgemäßer Gegenstand mit reflexionsmindernder Beschichtung weist ein Substrat und eine auf dem Substrat angeordnete Beschichtung auf. Diese Beschichtung ist mehrschichtig und umfasst gemäß einer ersten Variante zumindest eine Außenschicht (die also die Grenzfläche zu dem Umgebungsmedium des Gegenstands, insbesondere Luft, ausbildet) und eine weitere Schicht, die an die Außenschicht angrenzt und im Folgenden als "zweite Teilschicht" bezeichnet wird. Diese zweite Teilschicht ist auf der Außenschicht angeordnet und befindet sich im Regelfall unmittelbar in direktem mechanischen Kontakt mit der Außenschicht. Die Außenschicht besitzt einen Brechungsindex n₁, die zweite Teilschicht einen Brechungsindex n₂, wobei für diese Brechungsindizes gilt: n₂ > n₁ + 0,4 und bevorzugt gilt: n₂ > n₁ + 0,45. Ferner weist die Außenschicht einen Brechungsindex n, von zumindest 1,50 und meist auch von zumindest 1,55 auf und besitzt eine Schichthärte von zumindest 8 GPa. Häufig beträgt die Schichthärte zumindest 10 GPa. Die Außenschichtensind aus einer Verbindung der Summenformel a SiO₂ * b Al₂O₃ gebildet, wobei die Sauerstoffatome teilweise durch jeweils zwei Fluoratome ersetzt sein können; für die Indices a und b gilt, dass b > 0,65*a, dass a und b ganze Zahlen sind, und dass a und b ungleich 0 sind.

Erfindungsgemäß wurde erkannt, dass ein Gegenstand mit hervorragender reflexionsmindernder Beschichtung, die zudem sehr gute mechanische Eigenschaften besitzt, erhalten werden kann, wenn für die Außenschicht ein Material mit einer Schichthärte >8 GPa und insbesondere > 10 GPa eingesetzt werden kann. Derartige Materialien sind dem Fachmann zwar prinzipiell bekannt, allerdings weisen sie einen Brechungsindex auf, der sich zu wenig vom Brechungsindex der an die Außenschicht angrenzenden Teilschicht unterscheidet. Alternativ wurden nach dem Stand der Technik Materialien eingesetzt, die zwar einen passenden Brechungsindex hatten, allerdings eine zu geringe Schichthärte aufwiesen.

Mit dem nun beschriebenen Gegenstand wird ein Schichtsystem zur Verfügung gestellt, bei dem die Außenschicht (die beispielsweise aus einem Siliziumaluminiumoxid gebildet ist, d.h. daraus besteht oder dieses auch nur umfasst) einen Brechungsindex aufweist, der niedrig genug ist, um die Vorgaben hinsichtlich der Reflexionsminderung zu erfüllen (wenn beispielsweise eine Titandioxidschicht als zweite Teilschicht vorliegt, wie dies nach dem Stand der Technik häufig der Fall ist). Aufgrund der spezifischen Eigenschaften, die beispielsweise Siliziumaluminiumoxide besitzen, weist bei den erfindungsgemäßen Beschichtungen die Außenschicht eine besonders hohe Schichthärte auf. Dementsprechend ist der erfindungsgemäße Gegenstand mit reflexionsmindernder Beschichtung hervorragend für Anwendungen geeignet, bei denen starke mechanische Beanspruchungen auftreten oder auftreten können. Hier sind beispielsweise dem Wetter ausgesetzten Gegenstände, Gegenständen, die unter besonders drastischen Bedingungen gereinigt werden müssen oder generell hochwertige Materialien, bei denen jegliches Verkratzen unerwünscht ist, zu nennen.

Dass auf dem Substrat eine Beschichtung bzw. auf der "zweiten Teilschicht" eine Außenschicht angeordnet ist, kann hier und im Folgenden bedeuten, dass die Beschichtung unmittelbar in direktem mechanischen Kontakt mit dem Substrat beziehungsweise die "zweite Teilschicht" unmittelbar in direktem mechanischen Kontakt mit der Außenschicht angeordnet oder aufgebracht ist. Weiterhin kann die Beschichtung aber auch mittelbar auf dem Substrat beziehungsweise die Außenschicht mittelbar auf der "zweiten Teilschicht" angeordnet sein, d.h. es können weitere Schichten zwischen der zweiten Teilschicht und Außenschicht beziehungsweise zwischen Beschichtung und Substrat vorliegen. Beispielsweise können zwischen der eigentlichen reflexionsmindernden Beschichtung und dem Substrat weitere Schichten vorliegen, die zur Einstellung bestimmter Eigenschaften erforderlich sind; zwischen Außenschicht und zweiter Teilschicht können im Einzelfall ebenfalls noch spezifische Funktionsschichten vorliegen. Es können etwa - wie in der EP 1291331 A2 beschrieben - eine dünne Zwischenschicht aus Metall, insbesondere zur Verminderung der Reflexion der zweiten Teilschicht, und gegebenenfalls eine Blockerschicht zum Schutz einer derartigen Zwischenschicht vorliegen.

Die Schichthärte der Außenschicht wird in GPa gemessen. Als Messverfahren wird hierbei erfindungsgemäß die Nanoindentierung verwendet. Die Schichthärte ist hierbei nicht auf eine Messung der fertigen Beschichtung bzw. eines Gegenstands mit der Beschichtung bezogen, sondern wird an einer Reinschicht bestimmt, die aus dem jeweiligen Material besteht. Wird die Außenschicht beispielsweise mittels eines Sputterverfahrens erzeugt, so wird zur Messung der Schichthärte zunächst das Sputterverfahren auf einem Referenzsubstrat solange abgeschieden, bis eine ausreichende Schichtdicke erhalten wird, um die Nanoindentierung durchführen zu können. Die Messung kann nach der Norm ISO 14577-1:2002(E) erfolgen.

Wenn im Rahmen dieser Anmeldung von einem Brechungsindex mit einem bestimmten Wert die Rede ist, so bezieht sich dieser Wert stets auf die Messung des Brechungsindexes bei einer Wellenlänge von 550 nm.

Die Außenschicht ist aus einer Verbindung der Summenformel a SiO₂ * b Al₂O₃ gebildet (umfasst also diese Verbindung oder besteht daraus), wobei die Sauerstoffatome ggf. auch teilweise durch Fluoratome ersetzt sein können. Anders ausgedrückt könnte man diese Verbindung also auch mit der Summenformel Si_{f}Al_{g}OₕFₖ beschreiben. Der besseren Verständlichkeit halber wird aber die Formulierung verwendet, dass die Sauerstoffatome teilweise durch jeweils zwei Fluoratome ersetzt sein können. Bei der Formel a SiO₂ * b Al₂O₃ sind a und b ganze Zahlen (insbesondere ganze Zahlen von 1 bis 3); mit der Maßgabe, dass a und b ungleich null sind, wobei die Sauerstoffatome teilweise durch jeweils zwei Fluoratome ersetzt sein können und dass b > 0,65 * a ist.

Als wesentliche Vertreter der Verbindungen dieser Summenformel sind trimorphe Aluminiumsilikate zu nennen (die kein Fluor enthalten) sowie Siliziumaluminium-fluorooxide, Siliziumoxifluoride und Aluminiumoxifluoride. Für die Aluminiumsilizium-oxifluoride kann auch die Formel aufgestellt werden, dass für Gesamtanzahl der Anionen A der Formel a SiA₂ * b Al₂A₃ (bzw. a SiO₂ * b Al₂O₃ mit gegebenenfalls durch Fluor ersetztem Sauerstoff) und hinsichtlich ihrer Zusammensetzung aus Sauerstoff und Fluor gilt: Gesamtzahl der Anionen (Z) Z = 2 a + 3 b; Sauerstoff/Fluor-Anteil in Z: x * O + 0,5 y * F, wobei x + 0,5 y = 1 (hierbei sind x und y Dezimalzahlen oder ganze Zahlen und x ist ferner größer null). Als Beispiele für Siliziumaluminiumoxifluoride seien die Verbindungen Al₂SiO₄F₂ und Al₂SiO₃F₄ genannt.

Die Außenschicht kann entweder vollständig aus einer Verbindung der Summenformel a SiO₂ * b Al₂O₃ mit ggf. teilweise durch Fluor ersetzten Sauerstoffatomen bestehen, sie kann auch nur im Wesentlichen aus dieser Verbindung bestehen oder diese Verbindung auch nur umfassen. Im Wesentlichen daraus bestehen heißt dabei, dass zumindest 95 Gew.-%, beispielsweise zumindest 98 Gew.-% der Außenschicht aus dieser Verbindung gebildet ist. Der Rest kann beispielsweise eine der üblichen Verunreinigungen sein; es kann aber auch absichtlich Stickstoff in das Kristallgitter eingebaut werden, da dies zu einer Erhöhung der Härte führen kann. Im Regelfall wird es bei Außenschichten, die im Wesentlichen aus der genannten Verbindung bestehen, so sein, dass die Kristallstruktur bzw. Kristallstrukturen der Außenschicht vollständig der entspricht, die durch eine oder mehrere Reinverbindungen der Summenformel a SiO₂ * b Al₂O₃ (mit ggf. statt Sauerstoff eingebauten Fluoratomen) besteht.

Bei Außenschichten, die die Verbindung der Summenformel a SiO₂ * b Al₂O₃ mit ggf. teilweise durch Fluor ersetzten Sauerstoffatomen nur umfassen und die daher einen geringeren Gehalt der Verbindung der Summenformel a SiO₂ * b Al₂O₃ (mit ggf. statt Sauerstoff vorliegenden Fluoratomen) haben, kann die Außenschicht auch ein Gefüge aufweisen, in dem neben Kristallisationsformen der Verbindung der Summenformel a SiO₂ * b Al₂O₃ noch Bereiche mit anderen Kristallstrukturen (die auf andere Verbindungen zurückgehen) vorliegen. Häufig werden allerdings zumindest 75 Gew.-%, beispielsweise zumindest 90 Gew.-% der Außenschicht auf der Verbindung der Formel a SiO₂ * b Al₂O₃ beruhen, und unabhängig hiervon werden häufig zumindest 75 Gew.-%, beispielsweise zumindest 90 Gew.-% die Kristallstruktur einer Verbindung der Formel a SiO₂ * b Al₂O₃ besitzen. Sinnvollerweise wird man das Material des Anteils, der nicht auf a SiO₂ * b Al₂O₃ entfällt, so wählen, dass gegenüber einer Reinschicht aus dem korrespondierenden Material der Formel a SiO₂ * b Al₂O₃ eine Veränderung des Brechungsindexes um maximal 0,2, insbesondere maximal 0,1, zu verzeichnen ist. Als derartige Materialen kommen beispielsweise TiO₂, ZrO₂ und/oder HfO₂ in einem Anteil von bis zu 10 mol% (beispielsweise 5 mol% und weniger) und alternativ oder zusätzlich Nitride wie AIN oder Si₃N₄ in einem Anteil von bis zu 10 mol% (beispielsweise 5 mol% und weniger) in Betracht. Entsprechendes gilt für MgF₂.

Gemäß einer bevorzugten Ausführungsform umfasst die Außenschicht eine Verbindung der Formel SiₐAl_{2b}O_{(2a+3b)} und/oder eine Verbindung der Formel SiₐAl_{2b}O_{x(2a+3b)}F_{y(2a+3b)} oder besteht aus einer derartigen Verbindung. Hierbei sind die Indizes a, b, x und y wie vorstehend definiert, wobei allerdings gilt, dass a, b und y ungleich null sind. Als Beispiele seien genannt für a = 1, b = 1 die Verbindung SiAl₂O₅ und für a = 1, b = 1, x = 0,8 und y = 0,4 die Verbindungen SiAl₂O₅ und SiAl₂O₄F₂.

Mit Außenschichten, die aus diesen Verbindungen gebildet sind, können die Vorgaben hinsichtlich Brechungsindex und Schichthärte der Außenschicht besonders gut realisiert werden.

Erfindungsgemäß wurde beobachtet, dass sich mit höheren Aluminiumoxid-Anteilen besser Nanokristallinität (und damit höhere Schichthärten) erzielt werden kann. Auf der anderen Seite ist für Materialien mit hohen Anteilen an amorpher Phase oder vollständig amorphen Materialien (siehe nachfolgende Absätze) ein niedrigerer Anteil an Aluminiumoxid vorteilhafter hinsichtlich der Verschleißeigenschaften der Schicht, beispielsweise mit b < 0,33*a (bezogen auf die Summenformel a SiO₂ * b Al₂O₃; nicht erfindungsgemäß).

Gemäß einer Ausführungsform ist die Verbindung der Formel a SiO₂ * b Al₂O₃ (mit ggf. durch Fluor ersetzten Sauerstoffatomen) nanokristallin oder im Wesentlichen nanokristallin. Unter nanokristallin ist hierbei zu verstehen, dass die Verbindung a SiO₂ * b Al₂O₃ nicht in der amorphen Phase vorliegt. Im Wesentlichen nanokristallin bedeutet hierbei, dass zumindest 50 %, beispielsweise mindestens 90 %, der Verbindung nicht in der amorphen Phase vorliegt (wobei bezüglich der als nanokristallin zu bezeichnenden Korngrößen die im nachfolgenden Absatz angegebene Messung mittels Rasterelektronenmikroskopie zugrunde gelegt wird). Gemische aus amorpher und kristalliner Phase können quantitativ mittels Transmissions-Elektronen-Mikroskopie (TEM) untersucht werden; hierbei kann insbesondere auch der Anteil der amorphen Phase festgestellt werden.

Ferner bedeutet nanokristallin bzw. im Wesentlichen nanokristallin, dass auch innerhalb der Außenschicht keine Korngrößen >100 nm vorliegen und im Wesentlichen nanokristallin, dass maximal 10 % Korngrößen > 100 nm vorliegen, beispielsweise maximal 5 %. Diese Werte werden mittels Röntgenbeugung ermittelt. Korngrößen von mehr als 100 nm würden zu einer unerwünschten optischen Streuung führen. Vorzugsweise wird eine Korngröße zwischen 10 nm und 30 nm angestrebt, die dann insbesondere zu mindestens 90 % z.B. mindestens 95 % in der Außenschicht vorliegen sollte. Für die Bestimmung der Korngrößen werden hierbei die mittels Rasterelektronenmikroskopie ermittelten Werte zugrunde gelegt (hierbei werden nur Korngrößen ab ca. 5 nm erfasst; nur diese sind damit im Sinne dieser Erfindung nanokristallin).

Zusammengefasst erfüllt eine Verbindung die Vorgabe "nanokristallin", wenn mittels Röntgenbeugung keine amorphen Anteile ermittelt werden können und auch keine Korngrößen >100 nm. Im Wesentlichen nanokristallin bedeutet, dass mindestens 50 % der Verbindung nanokristallin vorliegen und zusätzlich weniger als 10 % Korngrößen >100 nm aufweisen, also zumindest 80 % nicht amorph sind und eine Korngröße kleiner oder gleich 100 nm besitzen.

Bevorzugt sind zumindest 90% (beispielsweise zumindest 95%) der Korngrößen des nanokristallinen Anteils bzw. der vollständig nanokristallinen Schicht 2 bis 100 nm, insbesondere 2 bis 20 nm und besonders bevorzugt 5 bis 10 nm (jeweils gemessen mittels Röntgenbeugung).

Eine Schicht mit einer Verbindung der Formel a SiO₂ * b Al₂O₃, die vollständig nanokristallin ist bzw. im Wesentlichen nanokristallin ist, erfüllt zum einen die Vorgabe besonders hoher Härte und zum anderen führt sie auch zu wenig Streuverlusten. Amorphe Anteile führen nämlich zu einer Erniedrigung der Schichthärte, während zu grobe Korngrößen zu Streuprozessen führen.

Besonders einfach kann eine Schicht mit hohem nanokristallinen Anteil oder eine vollständig nanokristalline Schicht realisiert werden, wenn die Außenschicht mittels Pulse Magnetron Sputtering oder mittels eines Verfahrens, bei dem während der Abscheidung der Außenschicht am Substrat / abgeschiedenen Schichtsystem eine erhöhte Temperatur von mehr als 200°C, insbesonder mehr als 300°C vorhanden ist. Um besonders gute Ergebnisse zu erhalten, kann auch eine Temperatur größer 500°C, beispielsweise größer 600 °C verwendet werden. Um die Ergebnisse hinsichtlich Schichthäre und Kristallinität weiter zu verbessern, kann zusätzlich noch ein elektrisches oder magnetisches Potential am Substrat angelegt werden. Vorzugsweise wird bei Glassubstraten ein Wechselfeldpotenzial angelegt.

Gemäß einer weiteren Ausführungsform weist die Außenschicht einen Brechungsindex n₁ zwischen 1,50 und 1,75, beispielsweise zwischen 1,55 und 1,75, auf und insbesondere einen Brechungsindex n₁, der zwischen 1,50 und 1,70, beispielsweise zwischen 1,55 und 1,70, liegt. Mittels derartiger Brechungsindizes der Außenschicht ist eine besonders gute reflexionsmindernde Wirkung zu verzeichnen.

Unabhängig von den im vorstehenden Absatz genannten Werten für den Brechungsindex n₁ kann eine besonders gute reflexionsmindernde Wirkung dann erreicht werden, wenn für die Relation zwischen dem Brechungsindex der Außenschicht und dem der zweiten Teilschicht gilt, dass die Quadratwurzel des Brechungsindex n₂ der zweiten Teilschicht in etwa dem Brechungsindex der Außenschicht entspricht. Allerdings sind für n₁ = 1.70 keine optisch transparenten Materialien bekannt, die einen Brechungsindex von 2.89 haben. In diesem Fall lässt sich durch die Verwendung mehrerer Schichten ebenfalls eine Entspiegelung erreichen. Als günstig hat sich herausgestellt, als Material der zweiten Teilschicht eines mit einer ebenfalls hoher Härte auszuwählen. ZrO₂ (n = 2.20) oder HfO₂ (n = 2.25) sind geeignete Materialien. Ggf. kann durch Mischung mit einem hochbrechenden Material (TiO₂) der Brechungsindex noch weiter erhöht werden.

Gemäß einer weiteren Ausführungsform weist die Außenschicht eine Schichthärte auf, die größer ist als 15 GPa, bevorzugt größer als 20 GPa. Mittels einer derartigen Schichthärte der Außenschicht kann ein besonders hochwertiger beschichteter Gegenstand erhalten werden, insbesondere wenn der Brechungsindex der Außenschicht zusätzlich kleiner als 1,75 ist und ferner insbesondere im Bereich zwischen 1,50 und 1,70, beispielsweise zwischen 1,55 und 1,70, liegt. Außenschichten mit derartigen Schichthärten sind insbesondere dann erreichbar, wenn die Außenschicht aus einem wie vorstehend definierten nanokristallinen oder im wesentlichen nanokristallinen Material besteht und unabhängig davon auch insbesondere dann, wenn das Material der Außenschicht aus einem Siliziumaluminiumoxid oder einem Aluminiumsiliziumoxifluorid besteht oder im Wesentlichen keine anderen Materialien enthält.

Gemäß einer weiteren Ausführungsform wird für die zweite Teilschicht der Beschichtung ein Material gewählt, das ein Oxid eines Metalls der IV. oder V. Nebengruppe des Periodensystems (z.B. Titanoxid, Zirkonoxid, Hafniumoxid, Nioboxid und/oder Tantaloxid - wobei unter "-oxid" wie stets im Rahmen dieser Anmeldung in Bezug auf das Kation Oxide jeglicher Stöchiometrie gemeint sind) ist, ein Fluorid eines dieser Elemente ist oder ein Oxifluorid eines dieser Elemente ist oder Zinnoxid, Zinkoxid, Siliziumnitrid, Aluminiumnitrid, Ceroxid, Chromoxid, oder Bismutoxid ist. Ferner kann die zweite Teilschicht auch aus einem Gemisch der genannten Stoffe bestehen oder aus einem Gemisch von einem oder mehreren der genannten Stoffe mit weiteren nicht genannten Stoffen. Schließlich kann die zweite Teilschicht auch nur im Wesentlichen aus einem der genannten Stoffe gebildet sein, d.h. insbesondere mehr als 80 Gew.-% eines der genannten Stoffe enthalten.

Gemäß einer weiteren Ausführungsform wird die zweite Teilschicht häufig einen Brechungsindex aufweisen, der zumindest 2,0 beträgt, insbesondere aber zumindest 2,1 oder sogar zumindest 2,2 ist. Unabhängig hiervon sollte auch die zweite Teilschicht eine hohe Härte aufweisen. Um dies zu erreichen, wird die zweite Teilschicht vielfach aus Zirkonoxid oder Hafniumoxid bestehen oder Zirkonoxid und /oder Hafniumoxid als Hauptkomponente enthalten. Gegebenenfalls kann auch Titanoxid als Hauptkomponente vorliegen, insbesondere wenn die zweite Teilschicht aus Titandioxid und aus Zirkonoxid und/oder Hafniumoxid besteht oder diese Stoffe enthält. Als Hauptkomponente ist hierbei zu verstehen, dass diese Komponente vom Gewichtsanteil her den größten Anteil besitzt, insbesondere einen Anteil größer 50 Gew.-% Denkbar ist auch eine zweite Teilschicht, die HfO₂ und/oder ZrO₂ und Nb₂O₅ enthält oder hieraus besteht. Insbesondere sind also reines Hafniumoxid bzw. Zirkonoxid und Gemische dieser beiden Stoffe mit TiO₂ zu nennen sowie Schichten, die diese Verbindungen zumindest zu 70 Gew.-%, insbesondere zu zumindest 90 Gew.-% enthalten. Als günstig hat sich auch erwiesen, das Zirkonium so auszuwählen, dass es in der Hochtemperaturphase stabilisiert. Dies kann erreicht werden durch die Zugabe von Yttrium oder auch durch Tantal in der Mischphase.

Generell kann die zweite Teilschicht also auch aus einem Mischmaterial gebildet sein. Beispielsweise kann, um die Härte der zweiten Teilschicht zu erhöhen, Hafniumoxid enthalten sein (insbesondere in einer Schicht aus Titanoxid und/oder Zirkonoxid).

Gemäß einer weiteren Ausführungsform kann das Substrat insbesondere ein Vitroid sein, also ein Stoff nach Art eines Glases. Zu nennen sind insbesondere organische und anorganische Vitroide, insbesondere sind hierbei Kunststoffe, Gläser, Saphir aber auch Metalle zu nennen. Im Regelfall handelt es sich hierbei um volltransparente Materialien, insbesondere transparente Materialien oxidischer Natur oder aus Kunststoff.

Um eine gute entspiegelnde Wirkung zu erzielen, wird das Substrat, insbesondere wenn die zweite Teilschicht einen Brechungsindex >2,1 aufweist, einen Brechungsindex besitzen, der kleiner als der der zweiten Teilschicht ist, oft sogar deutlich kleiner (d.h. um mindestens 0,4 kleiner).

Gemäß einer weiteren Ausführungsform umfasst die Beschichtung mindestens vier Teilschichten, insbesondere ein Schichtsystem, in dem alternierend Teilschichten aus einem ersten Material mit höherem Brechungsindex und Teilschichten aus einem zweiten Material mit niedrigerem Brechungsindex vorliegen. Häufig wird die Anzahl der Teilschichten zwischen 4 und 20 liegen, beispielsweise zwischen 4 und 10 (wobei die Bereichsgrenzen mit eingeschlossen sind). Eine Beschichtung mit sechs Teilschichten wird oft zu einem besonders vorteilhaften Kompromiss aus Wirtschaftlichkeit (wenige Schichten) und guter entspiegelnder Wirkung führen, da die Gesamtdicke der Beschichtung sinnvollerweise häufig nicht mehr als 400 nm, beispielsweise nicht mehr als 300 nm, beträgt. Je nach Anwendung sind aber auch niedrigere Restreflexionen gewünscht, so dass auch bis zu 20 Schichten vorliegen können, die Gesamtdicke kann dann bis zu 2000 nm betragen.

Die Schichtdicken der einzelnen Teilschichten der Beschichtung variieren hierbei; die sinnvollerweise zu wählenden Schichtdicken bei einer bestimmten Anzahl von Teilschichten ist dem Fachmann hierbei bekannt und können auch mittels Designprogrammen ermittelt werden. Die physikalische Schichtdicke der Außenschicht beträgt häufig zwischen 50 und 150 nm, insbesondere zwischen 70 und 120 nm. In der Regel wird hierbei eine Lambda/4n Schichtdicke angestrebt, wobei Lambda die Zentralwellenlänge der Entspiegelung ist (im Falle von Breitbandentspiegelung liegt der Wert etwa in der Mitte des Spektralbereiches) und n der Brechungsindex der Schicht. Derartige Schichtdicken haben sich als sinnvoll erwiesen, um eine ausreichende mechanische Stabilität zu erreichen.

Gemäß einer zweiten Variante der Erfindung liegt die Beschichtung zumindest teilweise als Nanolaminat vor. Die Beschichtung weist dann zumindest eine mehrschichtige Außenschicht (erfindungsgemäß stets die Schicht, die mit dem Umgebungsmedium, insbesondere Luft, eine Grenzfläche bildet) auf und umfasst ein erstes Material mit einem Brechungsindex n₁ und ein zweites Material mit einem Brechungsindex n₂, wobei die Außenschicht in Form eines Nanolaminats mit alternierenden Schichten aus dem ersten und dem zweiten Material vorliegt. Für die Brechungsindizes n₂ und n, gilt n₂ > n, + 0,4, und ferner ist die Schichthärte des Nanolamitas größer 8 GPa, häufig größer 10 GPa, bevorzugt größer 15 GPa, besonders bevorzugt größer als 20 GPa. Hinsichtlich des ersten und des zweiten Materials aber auch hinsichtlich des Aufbaus des beschichteten Gegenstands insgesamt gelten die vorstehenden Angaben für die erste Variante entsprechend, wobei das erste Material dem Material der Außenschicht der ersten Variante entspricht und das zweite Material dem Material der zweiten Teilschicht der ersten Variante. Insbesondere wird ein derartiges Nanolaminat bei einer Beschichtung in dem Bereich vorliegen, in dem sonst eine vollständig aus einem Material gebildete Außenschicht angeordnet ist. Die vorstehenden Ausführungen zu der Anzahl der Schichten gelten somit im Regelfall entsprechend, wobei dann jeweils statt einer Außenschicht ein Nanolaminat vorliegt. Auf die Nanolaminat-Außenschicht folgt gemäß dieser Variante insbesondere eine zweite Teilschicht, wie sie in der ersten Variante beschrieben ist oder alternativ eine Teilschicht, die aus dem Material mit dem Brechungsindex n₁ gebildet ist.

Unter einem Nanolaminat soll hier ein aus mehreren miteinander verbundenen dünnen Teilschichten bestehender Schichtstapel bezeichnet werden. Die Anzahl der Schichten orientiert sich dabei an der Dicke der zu ersetzenden homogenen Schicht; insbesondere hat eine Nanolaminatschicht eine Dicke von ca. 1 bis 8 nm, bevorzugt 2-4 nm. Eine homogene Schicht mit einer Dicke von 100 nm kann dann also durch eine Nanolaminat-Multischicht mit 20 bis 100 Einzelschichten ersetzt sein. Die Brechungsindizes und die Dicken der Schichten der Nanolaminatschicht werden dabei so gewählt, dass optisch (z.B. im Reflexionsspektrum) kein Unterschied zur homogenen Mischschicht festzustellen ist. Hierbei liegen dann im Regelfall alternierende Schichten aus dem ersten und dem zweiten Material vor.

Mittels einer derartigen Nanolaminatstruktur können in vorteilhafter Weise die Eigenschaften der Außenschicht und der hochbrechenden zweiten Teilschicht miteinander vereint werden. Durch den Nanolaminat-Effekt wird bei gleich bleibendem Brechungsindex die mechanische Härte nochmals erhöht; dies für die erfindungsgemäße Antireflexbeschichtung von Vorteil.

Die der vorliegenden Erfindung zugrundeliegende Aufgabe wird auch durch ein Verfahren zur Herstellung eines Gegenstands mit reflexionsmindernder Beschichtung, wie er vorstehend beschrieben wurde, gelöst. Hierbei wird auf einem Substrat eine zumindest zweischichtige Beschichtung abgeschieden, wobei zunächst die zweite (höherbrechende) Teilschicht mit einem Brechungsindex n₂ abgeschieden wird und nachfolgend die Außenschicht mit einem Brechungsindex n₁, der kleiner ist als der der zweiten Teilschicht, abgeschieden wird (beziehungsweise ein wie vorstehend beschriebenes Nanolaminat). Die Abscheidung erfolgt hierbei mittels physikalischer Gasphasenabscheidung oder chemischer Gasphasenabscheidung. Als besonders geeignete Abscheidungsverfahren haben sich Aufdampfen, Sputtern, insbesondere Magnetron-Sputtern, und Gasphasenabscheidung mittels Ionenstrahlen (lonenstrahlsputtern) erwiesen sowie im Bereich der chemischen Gasphasenabscheidung die plasmaunterstützte oder auch Heißdraht-CVD. Denkbar sind auch Tauchbeschichtungen (Sol-Gel Verfahren). Bezüglich der konkreten durchzuführenden Verfahrensschritte sei auch auf die dem Fachmann bekannten Standardnachschlagewerke verwiesen.

Besonders einfach kann die Abscheidung der Beschichtung bzw. der Teilschichtenbeschichtung (auch eines Nanolaminats) mittels Sputtern erfolgen. Wegen der guten Aufskalierbarkeit und der Möglichkeit, sehr harte Schichten abzuscheiden, ist dabei insbesondere das reaktive Magnetron-Sputtern zu nennen.

Beim Sputterverfahren kann vorzugsweise eine Geometrie eingesetzt werden, bei der eine räumliche Trennung von Reaktivgas und Beschichtungszone erreicht wird. Damit verbessert sich die Prozess-Stabilität und es können auch besonders gut Mischschichten hergestellt werden. Bei Plasmaprozessen können die Schichteigenschaften ebenfalls durch den Prozess beeinflusst und optimiert werden, wobei bei derartigen plasmagestützten Sputterprozessen die Härte einer Schicht dann sogar den Wert des Bulk-Materials übersteigen kann. Hierbei sind insbesondere die folgenden Prozessparameter zu optimieren: Leistung, Druck, Magnetfeld des Targets, Abstand zwischen Substrat und Target. Mittels Verfahren, insbesondere Sputterverfahren, bei denen ein elektrisches Potential am Substrat angelegt ist, können Ionen an das Substrat gezogen und in Kombination mit Temperatur kristalline Phasen bereits beim Schichtwachstum erzeugt werden. Noch leichter aufskalieren lassen sich Verfahren, bei denen eine höhere Ionisierung zu verzeichnen ist, beispielsweise bei gepulsten Plasmen oder HiPIMS-Prozessen; auch diese Verfahren führen zu kristallinen Phasen, die bereits beim Schichtwachstum ausgebildet werden.

Gemäß einer Ausführungsform wird das Verfahren so durchgeführt, dass eine fluorhaltige Schicht hergestellt werden kann, insbesondere eine Schicht, die aus einer Verbindung der Summenformel a SiO₂ * b Al₂O₃ gebildet ist, bei der die Sauerstoffatome teilweise durch Fluoratome ersetzt sind. Die Gasphasenabscheidung erfolgt dann unter Verwendung eines fluorhaltigen Targets und/oder eines fluorhaltigen Prozessgases. Da reines Fluor als Prozessgas aufgrund seiner starken Reaktivität im Regelfall problematisch ist, werden die Targets bzw. Prozessgase in Form von Fluorverbindungen eingesetzt. Hierbei sind sowohl organische als auch anorganische Materialien zu nennen. Als organische Materialien kommen insbesondere fluorierte Kohlenwasserstoffe oder perfluorierte Kohlenstoffverbindungen, beispielsweise CF₄, in Betracht, als anorganische Materialien sind insbesondere Metall- oder Halbmetall-Fluoride zu nennen, beispielsweise Aluminiumfluorid oder gegebenenfalls auch Siliziumfluorid. Die letztgenannten Fluoride haben den Vorteil, dass sie als Kation dieselben Metalle enthalten, die auch in der abzuscheidenden (Außen-)schicht enthalten sind. Bei den organischen Fluoriden sind insbesondere solche zu wählen, bei denen während des Sputterprozesses kein oder nur sehr wenig Kohlenstoff in die Schicht eingebaut wird. Insbesondere allenfalls eine so geringe Menge an Kohlenstoff, dass die Transparenz der Beschichtung nicht oder nicht wesentlich beeinträchtigt wird.

Die vorstehend beschriebene Beschichtung eignet sich insbesondere zur Herstellung bzw. Beschichtung hochwertiger Gegenstände. Sie lässt sich insbesondere für alle Flachglasprodukte einsetzen, beispielsweise Photovoltaik- und Solarthermie-Systeme, Kraftfahrzeuge, Sensorabdeckungen, Displays/Displaygläser, Gläser für Uhren, Architekturglas. Bei der Uhrenindustrie sind insbesondere Gläser für Schiffsuhren und Spezialuhren zu nennen, im Bereich der Schutzabdeckungen solche für Touch-Displays. Im Bereich der Gläser sind ferner Scheiben oder Windschutzscheiben von Kraftfahrzeugen, Fensterscheiben an Gebäuden, hochwertige Getränkegläser, Schmucksteine und Ähnliches zu nennen. Die Beschichtungen mit Außenschichten, die ein Material enthalten, das die Summenformel a SiO₂ * b Al₂O₃ (mit ggf. ersetzten Sauerstoffatomen) aufweist, sind ferner auch für Gegenstände hervorragend geeignet, die eine besondere hydrothermale Beständigkeit besitzen müssen, wie dies etwa in der Medizintechnik der Fall ist oder bei Gegenständen, die in warmfeuchter Umgebung eingesetzt werden. Auch zeigen diese Beschichtungen unabhängig hiervon häufig eine wasser- und ölabweisende Funktion, die für viele hochwertige Gegenstände ebenfalls gefordert wird.

Der vorstehend beschriebene Gegenstand mit Beschichtung bzw. das Verfahren zu dessen Herstellung erfüllt hinsichtlich der die Außenschicht sowohl die Anforderungen an die Reflexionsminderung und die mechanische Belastbarkeit. Wird der oxidische Anteil der Außenschicht teilweise durch Fluor ersetzt, so besteht auch eine Stellschraube, um den Brechungsindex der Außenschicht über einen weiten Bereich zu variieren, ohne dadurch die Schichthärte wesentlich zu beeinflussen. Mit Fluor steht dabei ein Element zur Verfügung, das im Gegensatz zu anderen den Brechungsindex reduzierenden Materialien / Elementen ungiftig ist. Schließlich ist es auch möglich, durch die fluoridischen Anteile die Hydrophobie, Oleophobie und Haptik genau für eine konkrete Anwendung einzustellen.

Weitere Vorteile und vorteilhafte Ausführungsformen und Weiterbildungen der Erfindung ergeben sich im Folgenden - ohne Einschränkung der Allgemeinheit - aus den Figuren und Beispielen. Hierbei zeigen:
- Figur 1: eine reflektionsmindernde Beschichtung mit vier Teilschichten,
- Figur 2: eine reflektionsmindernde Beschichtung mit vier Teilschichten, bei denen die äußerste Schicht als Nanolaminat ausgebildet ist
- Figur 3a bis 3f: die von der Wellenlänge abhängige Reflektivität für verschiedene Ausführungsbeispiele
- Figur 4a bis c: die unter verschiedenen Abscheidungsbedingungen erzielten Brechungsindizes, Härten und molaren Zusammensetzungen verschiedener Materialien der Außenschicht gemäß einem ersten Abscheidungsverfahren.
- Figur 5a und b: die unter verschiedenen Abscheidungsbedingungen erzielten Brechungsindizes und Härten verschiedener Materialien der Außenschicht gemäß einem zweiten Abscheidungsverfahren.
- Figur 6a und 6b: die von der Wellenlänge abhängige Reflektivität einer weiteren Ausführungsform (a: gerechnet; b: experimentell ermittelt)
- Figur 7: Sputteranordnung

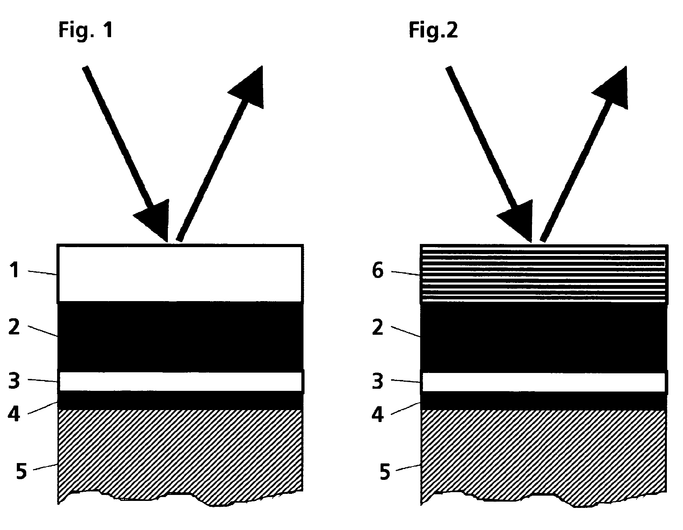

Figur 1 zeigt einen erfindungsgemäßen Gegenstand, bei dem die Beschichtung mit vier Teilschichten ausgebildet ist. Die Außenschicht (1) besteht hierbei beispielsweise aus SiAl₂O₄F₂ mit einer Schichtdicke von 85 nm. Die zweite Teilschicht (2) ist eine Mischschicht aus 20 Gew.-% Titandioxid und 80 Gew.-% Hafniumdioxid mit einer Schichtdicke von 110 nm, die dritte Teilschicht (3) ist aus demselben Material wie die Außenschicht (1) gebildet und 40 nm dick, die vierte Teilschicht (4) ist aus demselben Material wie Schicht (2) gebildet und direkt auf dem Substrat (5) aus Glas angeordnet.

Figur 2 zeigt ein Schichtsystem, das dem der Figur 1 entspricht, allerdings ist hierbei die Außenschicht (1) durch ein Nanolaminat (6), das aus den genannten Materialien gebildet ist, ersetzt. Die Schichtdicken entsprechen denen in Figur 1.

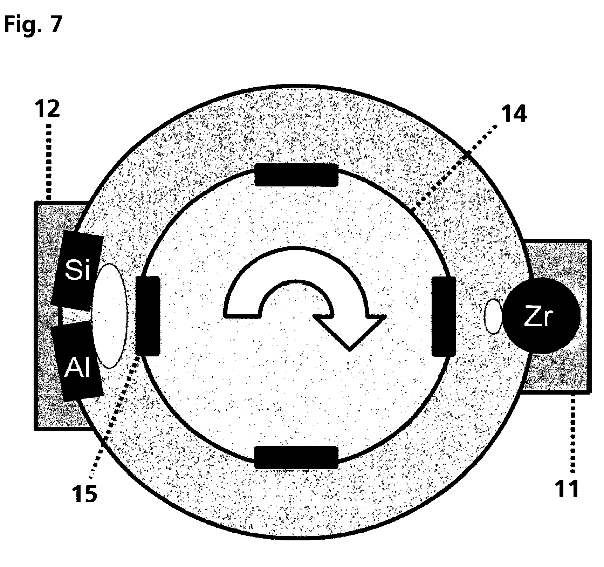

Figur 7 zeigt eine Sputteranordnung, wie sie erfindungsgemäß eingesetzt werden kann. Hierbei werden mittels eines Einzelmagnetrons (11) und eines Doppelmagnetrons (12) in einer rotierenden Drehtrommel (14) auf einem geheizten Probenhalter (15) Schichten aus Aluminiumsiliziumoxid beziehungsweise Zirconiumdioxid abgeschieden.

### Ausführungsbeispiele:

### Beispiel 1

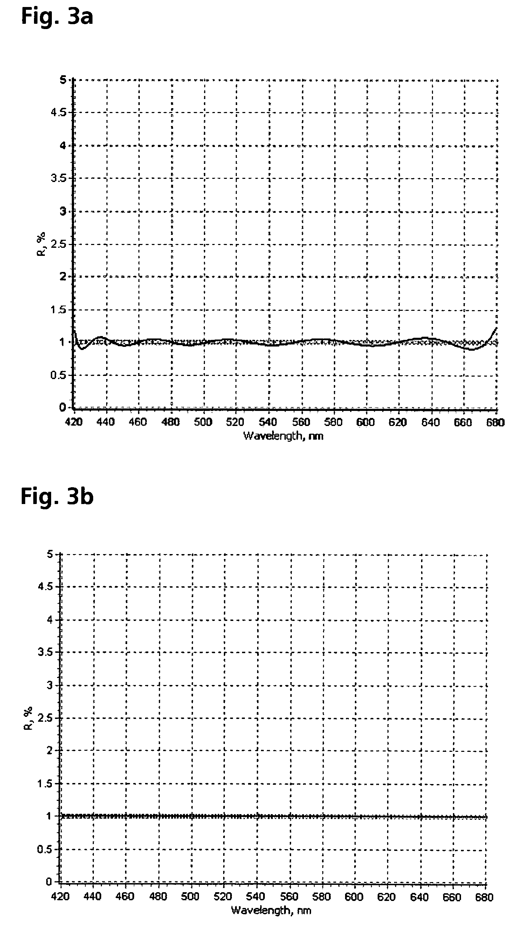

Figur 3a zeigt die Reflektivität abhängig von der Wellenlänge für eine AntireflexBeschichtung auf einem hochbrechenden Material (Saphir) mit einem Brechungsindex von 1,7 als Substrat. Für die Beschichtung wurden 13 Schichten verwendet. Die ungeraden Schichten bezeichnen ein gesputtertes Al2O3 mit 10 Gew.-% Si02 mit einem Brechungsindex von 1.69 (550 nm), die geraden Schichten sind aus einem Zr02 mit 10 Gew.-% Ti02 hergestellt. Zur Abscheidung der Schichten wurde ein Magnetron-Sputterverfahren eingesetzt, wobei zur Schichtabscheidung der niedrig brechenden AlSiOx-Schicht ein Doppelmagnetron eingesetzt wurde, welches mit einer Wechselspannung im Mittelfrequenzbereich (40 kHz) versorgt wird. Durch Einstellung unterschiedlicher Leistungen der beiden Targets kann sehr leicht die Mischung eingestellt werden. In dem Beispiel betrug die Leistung der Si-Targets 10% der Leistung des Aluminium Targets. Alternativ kann auch ein entsprechendes Al-Si-Mischtarget eingesetzt werden. Für das hochbrechende Material wurde ebenfalls ein Doppelmagnetron mit einem Zirkonium und einem Titan-Target eingesetzt. Die Leistung des Titan-Targets betrug 10% der Leistung des Zirkonium-Targets. Alternativ könnend die Sputtertargets des Doppelmagnetrons auch aus einem metallischen oder keramischen Mischtarget hergestellt sein.

In der nachfolgenden Tabelle sind Schichtdicken und Materialien aufgeführt, beginnend mit der auf dem Substrat angeordneten Schicht mit der Nummer 01:

| # | Physikalische Dicke [nm] | Material |
|---|---|---|
| 01 | 164,3 | Al2O3/SiO2 |
| 02 | 10,7 | ZrO2 / TiO2 |
| 03 | 56,8 | Al2O3/SiO2 |
| 04 | 16,6 | ZrO2/ TiO2 |
| 05 | 206,7 | Al2O3/SiO2 |
| 06 | 13,7 | ZrO2/ TiO2 |
| 07 | 206,1 | Al2O3/SiO2 |
| 08 | 17,3 | ZrO2/TiO2 |
| 09 | 198,5 | Al2O3/SiO2 |
| 10 | 22,5 | Zr02/ TiO2 |
| 11 | 170,3 | Al2O3/SiO2 |
| 12 | 74,0 | ZrO2 / Ti02 |
| 13 | 69,6 | Al2O3/SiO2 |

### Beispiel 2

Gemäß einem weiteren Ausführungsbeispiel wurde mit einer Al2O3-SiO2-Schicht mit 20 Gew.-% SiO2-Anteil und mit einem Brechungsindex von 1,58 auf Saphir als Substrat gearbeitet. Als hochbrechendes Material wurde ein Zr02-Material verwendet, welches 10 Gew.-% Ti02 zugemischt wurden, um den Brechungsindex etwas zu erhöhen. Das Zr02 lässt sich sehr hart herstellen und ist daher ebenfalls kratzfest. Eine harte zweite Teilschicht hilft, die Beständigkeit auch der Außenschicht zu verbessern. Figur 3b zeigt die Reflektivität abhängig von der Wellenlänge.

In der nachfolgenden Tabelle sind Schichtdicken und Materialien aufgeführt, beginnend mit der auf dem Substrat angeordneten Schicht mit der Nummer 01:

| # | Physikalische Dicke [nm] | Material |
|---|---|---|
| 01 | 19 | Al2O3/SiO2 |
| 02 | 7,2 | ZrO2/TiO2 |
| 03 | 58,0 | Al2O3/SiO2 |
| 04 | 5,0 | ZrO2/TiO2 |
| 05 | 122,0 | Al2O3/SiO2 |
| 06 | 11,5 | ZrO2/TiO2 |
| 07 | 41,4 | Al2O3/SiO2 |
| 08 | 43,5 | ZrO2/TiO2 |
| 09 | 5,7 | Al2O3/SiO2 |
| 10 | 71,0 | ZrO2/TiO2 |
| 11 | 84,5 | Al2O3/SiO2 |

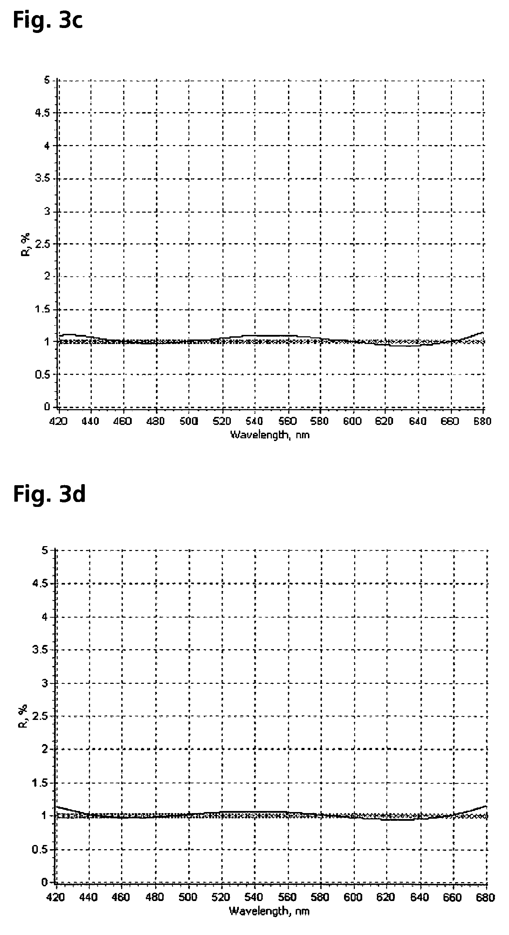

Oftmals ist es unpraktisch, sehr dünne Schichten (Dicke < 10 nm) abzuscheiden. Daher kann man diese Schichten weglassen und das Design wird - etwas auf Kosten der Restreflexion - vereinfacht. Figur 3c zeigt die Reflektivität abhängig von der Wellenlänge für ein Schichtsystem, das nur noch 7 statt 11 Schichten aufweist.

In der nachfolgenden Tabelle sind für das System mit reduzierter Schichtenzahl Schichtdicken und Materialien aufgeführt, beginnend mit der auf dem Substrat angeordneten Schicht mit der Nummer 01:

| # | Physikalische Dicke [nm] | Material |
|---|---|---|
| 01 | 25.5 | Al2O3/SiO2 |
| 02 | 5.5 | ZrO2/TiO2 |
| 03 | 177 | Al2O3/SiO2 |
| 04 | 13.9 | ZrO2/TiO2 |
| 05 | 24.3 | Al2O3/SiO2 |
| 06 | 107.4 | ZrO2/ TiO2 |
| 07 | 78 | Al2O3/SiO2 |

### Beispiel 3

Statt eines Saphir-Substrates wie in Beispiel 2 wurde hier ein niederbrechendes Glassubstrat (n=1,52) verwendet. Alle anderen Materialien sind identisch. Figur 3d zeigt die Reflektivität abhängig von der Wellenlänge.

In der nachfolgenden Tabelle Schichtdicken und Materialien aufgeführt, beginnend mit der auf dem Substrat angeordneten Schicht mit der Nummer 01:

| # | Physikalische Dicke [nm] | Material |
|---|---|---|
| 01 | 82 | Al2O3/SiO2 |
| 02 | 13.6 | ZrO2/TiO2 |
| 03 | 27.4 | Al2O3/SiO2 |
| 04 | 109.8 | ZrO2/TiO2 |
| 05 | 76.2 | Al2O3/SiO2 |

### Beispiel 4

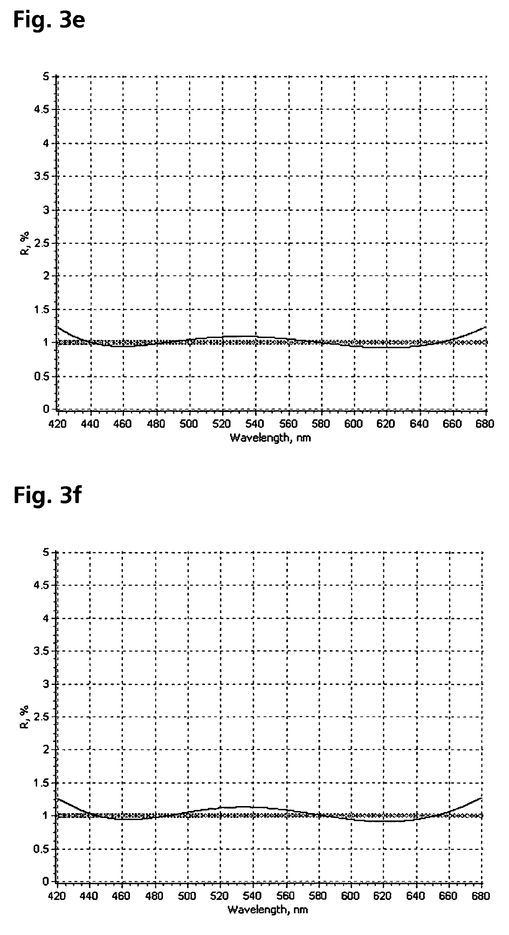

Statt Zr02-Ti02 als Material für die zweite Teilschicht wie in Beispiel 3 wurde reines Zr02 verwendet. Alle anderen Materialien sind identisch. Alle anderen Materialien sind identisch. Figur 3e zeigt die Reflektivität abhängig von der Wellenlänge.

In der nachfolgenden Tabelle Schichtdicken und Materialien aufgeführt, beginnend mit der auf dem Substrat angeordneten Schicht mit der Nummer 01:

| # | Physikalische Dicke [nm] | Material |
|---|---|---|
| 01 | 81 | Al2O3/SiO2 |
| 02 | 14.2 | ZrO2 |
| 03 | 25 | Al2O3/SiO2 |
| 04 | 106 | ZrO2 |
| 05 | 76 | Al2O3/SiO2 |

### Beispiel 5

Statt eines Saphir-Substrates wie in Beispiel 4 wurde hier ein niederbrechendes Glassubstrat (n=1,52) verwendet. Alle anderen Materialien sind identisch. Alle anderen Materialien sind identisch. Figur 3f zeigt die Reflektivität abhängig von der Wellenlänge. In der nachfolgenden Tabelle Schichtdicken und Materialien aufgeführt, beginnend mit der auf dem Substrat angeordneten Schicht mit der Nummer 01:

| # | Physikalische Dicke [nm] | Material |
|---|---|---|
| 01 | 32 | Al2O3/SiO2 |
| 02 | 22 | ZrO2 |
| 03 | 112 | Al2O3/SiO2 |
| 04 | 106 | ZrO2 |
| 05 | 76.5 | Al2O3/SiO2 |

### Beispiel 6

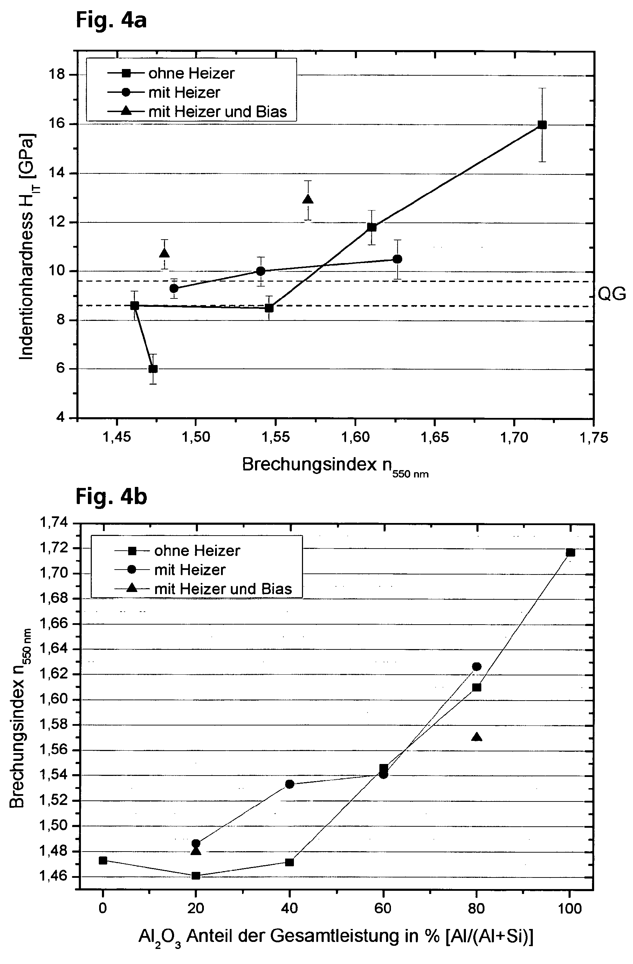

Figur 4a zeigt für verschiedene Materialien der Außenschicht die bei unterschiedlichen Abscheidungsbedingungen erzielten Brechungsindizes und Schichthärten. Es zeigt sich, dass sich im Vergleich zu einem herkömmlichen Sputterverfahren (Quadrate) sowohl der Brechungsindex vermindern lässt als auch die Härte erhöht werden kann, wenn beim Sputtern zusätzlich das Substrat beheizt wird (Kreise). Dies lässt sich noch weiter verbessern, wenn zusätzlich zur Beheizung des Substrats auch noch ein Potential am Substrat angelegt wird (Dreiecke). Bei Beheizung wurde eine Heizertemperatur von 500°C, gemessen am Substrat, eingestellt. Es wurde ein RF-Sputterprozess eingesetzt (Radiofrequenz: 13,56 MHz), wobei jeweils von zwei Targets (ein Aluminium- und ein SiliziumTarget) zugleich gesputtert wurde. Als Substrat wurde ein Quarzsubstrat eingesetzt.

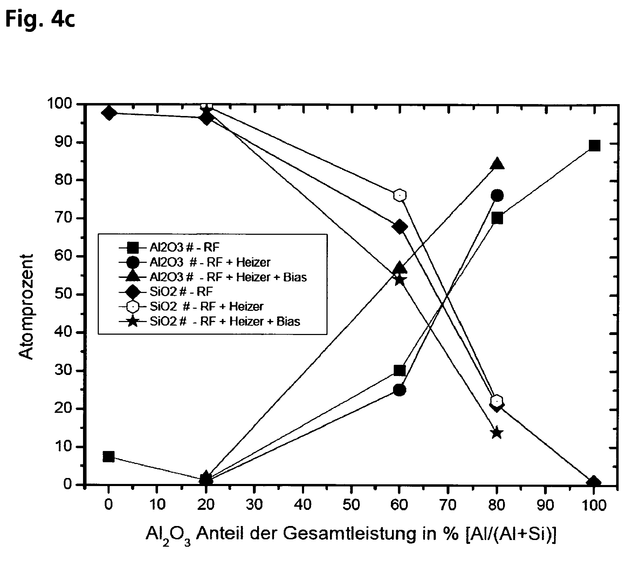

Die in Figur 4a angegebenen Brechungsindizes werden erhalten durch Einstellung unterschiedlicher Leistung der beiden Targets. Hierzu zeigt Figur 4b mit welchem Al2O3-Anteil an der Gesamtleistung (in %) bei den verschiedenen Abscheidungsbedingungen welcher Brechungsindex erhalten wird. Figur 4c zeigt schließlich den molaren Anteil von Al2O3 und Si02 in den erhaltenen Schichten für einen gegebenen Al2O3-Anteil an der Gesamtleistung (in %) gemäß Figur 4b bei den verschiedenen Abscheidungsbedingungen (herkömmliches Verfahren: Al2O3 - Quadrate, Si02 - Rauten / Verfahren mit Substratbeheizung: Al2O3 - Kreise, Si02 - Sechsecke / Verfahren mit Substratbeheizung und Potential: Al2O3 - Dreiecke, SiO2 - Sterne).

### Beispiel 7

Zur Bestimmung der Schichthärte wurden auf einem Saphir-Substrat Al2O3/SiO2-Schichten reaktiv im Übergangsmodus von einem Aluminium- und einem Siliziumtarget mit einer Dicke von 300-400 nm abgeschieden. Dabei wurde das Mischungsverhältnis in einem Mittelfrequenzprozess (5-30 kHz) durch Wahl des Verhältnisses der Pulszeiten des jeweiligen Targets eingestellt. Außerdem wurden Mischungen mit einem Sinus-Mittelfrequenzgenerator (40 kHz) hergestellt. Ein Probensatz befand sich auf einem Halter mit floatendem Potential, einer auf einem geheizten (Substrathalter ca. 300-450°C) und mit Bias (ca. doppelte Frequenz gegenüber dem Sputterprozess) versehenen sowie ein dritter auf einem nur mit Bias versehenem Halter.

Durch Wahl des Mischungsverhältnisses lassen sich Härte und Brechungsindex einstellen. Allerdings werden mit dem hier verwendeten gepulsten Verfahren die Schichthärten des im vorhergehenden Beispiel beschriebenen RF-Sputterprozesses nicht ganz erreicht.

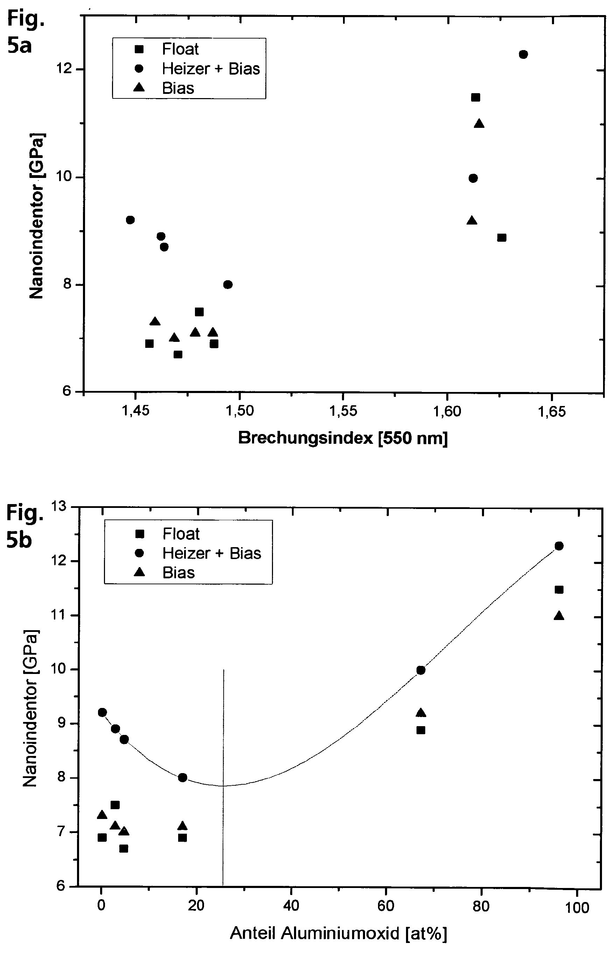

Die in Figur 5a angegebenen Brechungsindizes werden erhalten durch Einstellung unterschiedlicher Leistung der beiden Targets. Hierzu zeigt Figur 5b mit welchem Al2O3-Anteil (in Atom%) bei den verschiedenen Abscheidungsbedingungen welcher Brechungsindex erhalten wird. Auch hier zeigen die mit Substratbeheizung und Potential erhaltenen Schichten die besten Eigenschaften (herkömmliches Verfahren: Quadrate / Verfahren mit Potential: Dreiecke / Verfahren mit Substratbeheizung und Potential: Kreise).

### Beispiel 8 (nicth erfindungsgemäß)

In einer Sputteranordnung gemäß Fig. 7 wurde bei langsamer Drehung der Trommel (0,3 Upm) ein Nanolaminat abgeschieden. Am Doppelmagnetron war ein Sinus-Mittelfrequenzprozess (40 kHz) und am Einzelrohrmagnetron ein unipolarer Pulsprozess (50 kHz) im reaktiven, oxidischen Modus aktiv. Dabei ensteht ein Schichtstapel aus etwa 4 nm Zr02 und 10 nm Si02 im Wechsel.

Auf diese Weise konnte für das Nanolaminat eine Schichthärte durch Nanoindentierung von 10,0±0,3 GPa gemessen werden bei einem Brechungsindex von 1,69. Das Mischungsverhältnis und damit der Brechungsindex lässt sich durch Wahl der Leistung an den beiden Quellen einstellen.

### Beispiel 9 (nicth erfindungsgemäß)

Es wurde ein 5-Schicht-Antireflexsystem mit einer Aluminium-Siliziumoxid-Mischung als niedrigbrechendes Material abgeschieden. Die Mischung wurde mit dem reaktiven Prozess gemäß Beispiel 7 bei geringem Aluminiumoxidgehalt (ca. 5 Atom-%) hergestellt. Das Design wurde für einen Bereich von 400-700 nm auf Saphirsubstrat mit einer Gesamtdicke von 220 nm zunächst gerechnet und dann abgeschieden. Hierbei wurden auf dem Saphirsubstrat der Reihe nach folgende Schichten aufgebracht: Saphir/ SiAlOx 15nm/ Zr02 34nm/ SiAlOx 28nm/ Zr02 45nm/ SiAlOx 98nm. Als hochbrechendes Material kam gepulst (50 kHz) abgeschiedenes Zr02 zum Einsatz. Die Härte des Gesamtsystems beträgt 9,5±1 GPa.

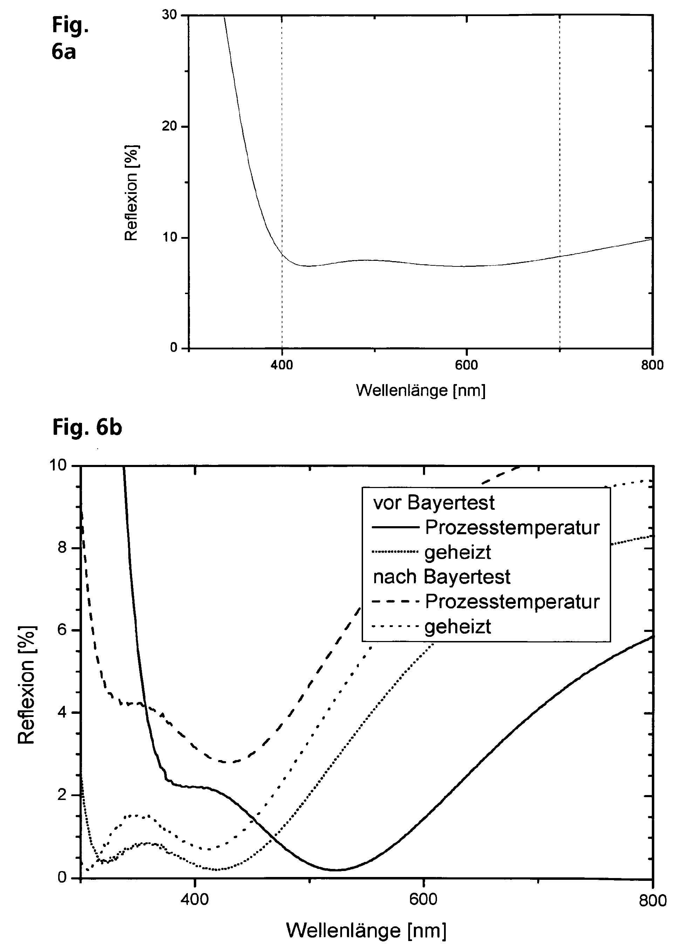

Die gerechnete Reflexionskurve für einseitige Beschichtung ist in Fig. 6a gezeigt. Das geheizte System zeigt eine verbesserte Beständigkeit gegen Abrasion im Bayertest (unter Bayertest wird hierbei die in der in EP 1148037 A1 beschriebene Version verstanden). Während hier das ungeheizte System einen Schichtdickenverlust von 38 nm aufweist, werden im geheizten nur 6 nm abgerieben. Auch ist der Anstieg des integrierten Haze nach Sandrieseltest (DIN 52 348 - 1985) mit 4,41 geringer als bei der ungeheizten Probe mit 5,54. Diese Ergebnisse können anhand der Messung der Reflexion auf einem Saphirsubstrat mit angerauhter Rückseite untermauert werden. In Fig. 6b ist die Reflexion jeweils vor und nach dem Bayertest dargestellt. Die Abweichung vom gerechneten Spektrum kommt durch einen noch nicht korrigierten Toolingfaktor zwischen Schichtdickenmonitor und Zielsubstrat zu Stande. Man erkennt, das beim geheizten System (gepunktete Linien) auch nach Durchführung des Bayertests hervorragende Ergenisse zu verzeichnen sind.

## Patentansprüche

1. Gegenstand mit reflexionsmindernder Beschichtung, der ein Substrat (5) und eine auf dem Substrat angeordnete Beschichtung aufweist, wobei die Beschichtung mehrschichtig ist und
entweder eine Außenschicht (1) aus einem ersten Material mit einem bei 550 nm gemessenen Brechungsindex n₁ und zumindest eine zweite Teilschicht (2) aus einem zweiten Material mit einem bei 550 nm gemessenen Brechungsindex n₂ umfasst, wobei die zweite Teilschicht (2) an die Außenschich (1) angrenzt, oder wobei die Beschichtung zumindest eine mehrschichtige Außenschicht in Form eines Nanolaminats (6) aus dem ersten und dem zweiten Material aufweist, wobei für den Brechungsindex n₂ jeweils gilt n₂ > n₁ + 0,4, und wobei das erste Material der Außenschicht einen Brechungsindex n, > 1,50 besitzt,
**dadurch gekennzeichnet, dass** das erste Material der Außenschicht eine Verbindung der Summenformel a SiO₂ * b Al₂O₃, worin die Sauerstoffatome teilweise durch jeweils zwei Fluoratome ersetzt sein können,
umfasst oder daraus besteht, wobei
a und b ganze Zahlen sind, mit der Maßgabe, dass a und b ungleich 0 sind und b > 0,65*a ist.

2. Gegenstand nach dem vorhergehenden Anspruch, wobei das erste Material der Außenschicht (1) eine Verbindung der Formel SiₐAl_{2b}O_{(2a+3b}) und/ oder eine Verbindung der Formel SiₐAl_{2b}O_{x(2a+3b)}F_{y(2a+3b)} umfasst.

3. Gegenstand nach einem der vorhergehenden Ansprüche, wobei die Verbindung der Formel a SiO₂ * b Al₂O₃ nanokristallin ist.

4. Gegenstand nach einem der vorhergehenden Ansprüche, wobei das erste Material der Außenschicht (1) einen Brechungsindex n₁ < 1,75 aufweist, für den insbesondere gilt n, < 1,7.

5. Gegenstand nach einem der vorhergehenden Ansprüche, wobei die zweite Teilschicht (2) ein Material enthält, das ausgewählt ist aus zumindest einem Oxid eines Metalls der IV. oder V. Nebengruppe, einem Fluorid eines Metalls der IV. oder V. Nebengruppe, einem Oxifluorid eines Metalls der IV. oder V. Nebengruppe, aus Aluminiumnitrid, SnO₂, ZnO, Si₃N₄, CeO₂, Bi₂O₃ und aus Gemischen der genannten Stoffe untereinander oder mit anderen Stoffen, oder wobei die zweite Teilschicht aus einem derartigen Material besteht.

6. Gegenstand nach einem der vorhergehenden Ansprüche, wobei
die Beschichtung mindestens 4 Teilschichten umfasst, wobei alternierend Teilschichten aus einem Material mit höherem und Teilschichten aus einem Material mit niedrigerem Brechungsindex vorliegen.

7. Gegenstand nach dem vorhergehenden Anspruch, wobei die Anzahl der Teilschichten 4 bis 20 beträgt und insbesondere 6 ist.

8. Verfahren zur Herstellung eines Gegenstands mit reflexionsmindernder Beschichtung nach einem der vorhergehenden Ansprüche, bei dem auf einem Substrat (5) eine zumindest zweischichtige Beschichtung abgeschieden wird, wobei zumindest eine zweite Teilschicht (2) mit einem Brechungsindex n₂ und nachfolgend eine Außenschicht (1) mit einem Brechungsindex n₁ < n₂ abgeschieden wird, wobei
die Abscheidung mittels physikalischer Gasphasenabscheidung oder chemischer Gasphasenabscheidung erfolgt.

9. Verfahren nach dem vorhergehenden Anspruch, wobei
die physikalische Gasphasenabscheidung mittels Aufdampfen, Sputtern, insbesondere Magnetronsputtern, oder mittels Ionenstrahlen erfolgt oder die chemische Gasphasenabscheidung plasmaunterstützt erfolgt.

10. Verfahren nach dem vorhergehenden Anspruch, wobei
die Gasphasenabscheidung unter Verwendung eines fluorhaltigen Targets und/oder eines fluorhaltigen Prozessgases erfolgt.

11. Verwendung des Gegenstands nach einem der Ansprüche 1 bis 7 für Photovoltaikanlagen, Flachglas, Objektive für Kameras, für medizintechnische Geräte, optische Messgeräte mit transparenten Abdeckungen, Displays, oder in der Uhrenindustrie.

## Claims

1. Article with a reflection-reducing coating, said article having a substrate (5) and a coating disposed on the substrate, the coating being multilayer and either comprising an outer layer (1) of a first material having a refractive index n₁ measured at 550 nm and at least one second part-layer (2) of a second material having a refractive index n₂ measured at 550 nm, the second part-layer (2) being adjacent to the outer layer (1),
or the coating having at least one multilayer outer layer in the form of a nanolaminate (6) comprising the first and second materials, wherein for the refractive index n₂ it holds in each case that n₂ > n₁ + 0.4, and wherein the first material of the outer layer possesses a refractive index n₁ > 1.50,
**characterized in that**
the first material of the outer layer comprises or consists of a compound of empirical formula a SiO₂ * b Al₂O₃, in which the oxygen atoms may in part have been replaced each by two fluorine atoms, wherein
a and b are integers, with the proviso that a and b are not 0 and b > 0.65*a.

2. Article according to the preceding claim, wherein the first material of the outer layer (1) comprises a compound of formula SiₐAl_{2b}O_{(2a+3b)} and/or a compound of formula SiₐAl_{2b}O_{x(2a+3b)}F_{y(2a+3b)}.

3. Article according to any of the preceding claims, wherein the compound of the formula a SiO₂ * b Al₂O₃ is nanocrystalline.

4. Article according to any of the preceding claims, wherein
the first material of the outer layer (1) has a refractive index n₁ < 1.75, for which more particularly it holds that n₁ < 1.7.

5. Article according to any of the preceding claims, wherein
the second part-layer (2) comprises a material selected from at least one oxide of a metal from transition group IV or V, a fluoride of a metal from transition group IV or V, an oxyfluoride of a metal from transition group IV or V, aluminum nitride, SnO₂, ZnO, Si₃N₄, CeO₂, Bi₂O₃, and mixtures of the stated substances with one another or with other substances, or wherein the second part-layer consists of such a material.

6. Article according to any of the preceding claims, wherein
the coating comprises at least 4 part-layers, wherein part-layers comprising a material having a higher refractive index alternate with part-layers comprising a material having a lower refractive index.

7. Article according to the preceding claim, wherein the number of part-layers is 4 to 20 and more particularly is 6.

8. Method for producing an article with a reflection-reducing coating according to any of the preceding claims, in which an at least two-layer coating is deposited on a substrate (5), wherein at least one second part-layer (2) having a refractive index n₂, and subsequently an outer layer (1) having a refractive index n₁ < n₂, are deposited, wherein the deposition takes place by means of physical gas phase deposition or chemical gas phase deposition.

9. Method according to the preceding claim, wherein the physical gas phase deposition takes place by means of vapor deposition, sputtering, more particularly magnetron sputtering, or by means of ion beams, or the chemical gas phase deposition takes place with plasma enhancement.

10. Method according to the preceding claim, wherein the gas phase deposition takes place using a fluorine-containing target and/or a fluorine-containing process gas.

11. Use of the article according to any of Claims 1 to 7 for photovoltaic systems, flat glass, camera lenses, for medical devices, optical measuring instruments with transparent covers, displays, or in the horological industry.

## Revendications

1. Article à revêtement antireflet, qui comporte un substrat (5) et un revêtement disposé sur le substrat, le revêtement étant multicouche et
soit comprenant une couche externe (1) à base d'un premier matériau ayant un indice de réfraction n₁ mesuré à 550 nm et au moins une deuxième sous-couche (2) à base d'un deuxième matériau ayant un indice de réfraction n₂ mesuré à 550 nm, la deuxième sous-couche (2) étant adjacente à la couche externe (1),
soit le revêtement comportant au moins une couche externe multicouche sous forme d'un nanostratifié (6) à base du premier et du deuxième matériau,
pour l'indice de réfraction n₂ s'appliquant chaque fois la relation n₂ > n₁ + 0,4 et le premier matériau de la couche externe ayant un indice de réfraction n₁ > 1,50, **caractérisé en ce que**
le premier matériau de la couche externe comprend ou consiste en un composé de formule brute a SiO₂ * b Al₂O₃, dans laquelle les atomes d'oxygène peuvent être en partie remplacés par chaque fois deux atomes de fluor, a et b étant des nombres entiers, étant entendu que a et b sont différents de 0 et b est > 0,65*a.

2. Article selon la revendication précédente, dans lequel le premier matériau de la couche externe (1) comprend un composé de formule SiₐAl_{2b}O_{(2a+3b)} et/ou un composé de formule SiₐAl_{2b}O_{x(2a+3b)}F_{y(2a+3b)}.

3. Article selon l'une quelconque des revendications précédentes, dans lequel le composé de formule a SiO₂ * b Al₂O₃ est nanocristallin.

4. Article selon l'une quelconque des revendications précédentes, dans lequel le premier matériau de la couche externe (1) présente un indice de réfraction n₁ < 1,75, pour lequel s'applique en particulier la valeur n₁ < 1,7.

5. Article selon l'une quelconque des revendications précédentes, dans lequel la deuxième sous-couche (2) contient un matériau qui est choisi parmi au moine un oxyde d'un métal du groupe IVB ou VB, un fluorure d'un métal du groupe IVB ou VB, un oxyfluorure d'un métal du groupe IVB ou VB, parmi le nitrure d'aluminium, SnO₂, ZnO, Si₃N₄, CeO₂, Bi₂O₃ et parmi des mélanges des substances nommées, entre elles ou avec d'autres substances, ou dans lequel la deuxième sous-couche consiste en un tel matériau.

6. Article selon l'une quelconque des revendications précédentes, dans lequel le revêtement comprend au moins 4 sous-couches, des sous-couches à base d'un matériau à plus haut indice de réfraction et des sous-couches à base d'un matériau à plus faible indice de réfraction se trouvant en alternance.

7. Article selon la revendication précédente, dans lequel le nombre des sous-couches vaut de 4 à 20 et en particulier est égal à 6.

8. Procédé pour la fabrication d'un article à revêtement antireflet selon l'une quelconque des revendications précédentes, dans lequel on dépose sur un substrat (5) un revêtement au moins bicouche, en déposant au moins une deuxième sous-couche (2) ayant un indice de réfraction n₂ et ensuite une couche externe (1) ayant un indice de réfraction n₁ < n₂,
le dépôt s'effectuant par dépôt physique en phase vapeur ou dépôt chimique en phase vapeur.

9. Article selon la revendication précédente, dans lequel le dépôt physique en phase vapeur s'effectue par vaporisation, pulvérisation cathodique, en particulier pulvérisation cathodique magnétron, ou au moyen de faisceaux ioniques ou le dépôt chimique en phase vapeur s'effectue en étant assisté par plasma.

10. Article selon la revendication précédente, dans lequel le dépôt en phase vapeur s'effectue avec utilisation d'une cible fluorée et/ou d'un gaz de processus contenant du fluor.

11. Utilisation de l'article selon l'une quelconque des revendications 1 à 7, pour des installations photovoltaïques, du verre plat, des objectifs pour appareils photographiques, pour des appareils médicotechniques, des appareils de mesure optiques à revêtements transparents, des afficheurs, ou dans l'industrie horlogère.
